# EUROPEAN PATENT APPLICATION

(11) **EP 4 733 432 A1**
(43) Date of publication of application: **29.04.2026**
(21) Application number: 24825224.9
(22) Date of filing: 18.06.2024
(51) Int. Cl.: C23C 14/35, C23C 14/56

(54) **SEMICONDUCTOR PROCESS APPARATUS AND PROCESS CHAMBER THEREOF**

(30) Priority: 21.06.2023 CN 202310745558
(71) Applicant: Beijing NAURA Microelectronics Equipment Co., Ltd., Beijing 100176 (CN)
(72) Inventor: WANG, Lei, Beijing 100176 (CN); LI, Bing, Beijing 100176 (CN); LI, Qiang, Beijing 100176 (CN); HU, Shuopeng, Beijing 100176 (CN); ZHAO, Kangning, Beijing 100176 (CN); YANG, Yilong, Beijing 100176 (CN)
(74) Representative: Cohausz & Florack
(86) International application number: PCT/CN2024/099762
(87) International publication number: WO 2024/260329

(57) **Abstract**

A semiconductor sputtering process equipment is disclosed. The sputtering equipment comprises a cavity, a substrate support for the wafers, a contamination shutter disk and its carrier, and its calibration mechanism. The calibration mechanism is arranged on the cavity. The contamination shutter disk is switched between a first position and a second position by the carrier. When the shutter disk is at the first position, it is away from the substrate support. The calibration mechanism adjusts the shutter disk to a preset position on the carrier. When the shutter disk is at the preset position on the carrier and the carrier drives the shutter disk to move to the second position, the shutter disk is positioned above the substrate support, and a spacing between a first central axis of the shutter disk and a second central axis of the substrate support is less than or equal to a first preset distance.

## Description

### FIELD OF THE INVENTION

The present disclosure relates to the technical field of semiconductor process devices, and in particular, to a semiconductor process device and a process chamber thereof.

### BACKGROUND OF THE INVENTION

Sputtering is one of the most widely adopted deposition techniques in semiconductor fabrication. In this technique, an ion beam is used to bombard the surface of a target material so as to generate plasma, causing atoms to be ejected from the target. These atoms then deposit onto the wafer surface, forming a thin film. However, during target replacement, the exposed surface of the target is prone to adsorbing impurities from the ambient environment. To ensure high film quality, it is therefore essential to perform a thorough cleaning of the target before initiating the sputtering process. Moreover, as sputtering continues over an extended period, reaction byproducts and other contaminants tend to accumulate on the target surface. The residuals can become incorporated into the disposed thin film, potentially degrading its performance and product reliability. Consequently, periodic cleaning of the target is not merely a preparatory step; it is an essential part of the overall sputtering workflow.

During the target cleaning process, the semiconductor equipment typically employs a shutter disk to cover the substrate support. This helps prevent impurities from settling onto the substrate support and causing contamination. However, one challenge arises from the fact that the shutter disk can easily shift out of position during operation. Such misalignment may compromise the effectiveness of the shielding and increase the risk of substrate support contamination.

### SUMMARY OF THE INVENTION

The present disclosure provides a semiconductor process device and its process chamber to address impurities contamination deposited onto the substrate support due to shutter disk's position shift.

The present disclosure provides the following technical solutions.

A first embodiment of the present disclosure provides a process chamber of a semiconductor process device. The process chamber comprises a cavity, a calibration mechanism, and a substrate support, a carrier and a shutter disk arranged in the cavity. The calibration mechanism is arranged on the cavity, and when the shutter disk is carried by the carrier, the shutter disk is configured to switch between a first position and a second position along with the carrier.

When the shutter disk is at the first position, the shutter disk is away from the substrate support, and the calibration mechanism adjusts the shutter disk to a preset position on the carrier.

When the shutter disk is located at the preset position on the carrier, and the carrier drives the shutter disk to move to the second position, the shutter disk is located above the substrate support, and a spacing between a first central axis of the shutter disk and a second central axis of the substrate support is less than or equal to a first preset distance.

A second embodiment of the present disclosure provides a semiconductor process device comprising the process chamber as described in any one of the examples provided in the first embodiment of the present disclosure.

The technical solutions disclosed in the present disclosure deliver the following beneficial effects.

In the present disclosure, the process chamber introduces a carrier that enables the shutter disk to switch between a first position and a second position. When the shutter disk is at the first position, it is away from the substrate support, allowing the calibration mechanism to perform alignment without interference. This ensures that the shutter disk can be accurately adjusted to a preset position on the carrier. Once the shutter disk reaches the preset position, the carrier can then drive it to the second position. In this state, the shutter disk remains at the preset position while achieving alignment with the substrate support at the second position. By calibrating the shutter disk prior to its movement into alignment with the substrate support, this approach avoids performing calibration directly above the substrate support. As a result, it prevents particles generated by friction during movement of the shutter disk in the calibration process from falling onto the substrate support, thereby avoiding contamination of the substrate support.

### BRIEF DESCRIPTION OF DRAWINGS

FIG. 1 is a schematic structural diagram of a semiconductor process device in an example of the present disclosure, with a shutter disk in a first position.
FIG. 2 is a schematic structural diagram of the semiconductor process device shown in FIG. 1, with the shutter disk in a second position.
FIG. 3 is a schematic structural diagram of a calibration mechanism in an example of the present disclosure.
FIG. 4 is a schematic diagram showing a portion of the calibration mechanism shown in FIG. 3.
FIG. 5 is an enlarged schematic diagram of the portion of the calibration mechanism shown in FIG. 4.
FIG. 6 is a schematic diagram illustrating the interaction between the conical protrusion and the shutter disk after the shutter disk has been lifted by the conical protrusion.
FIG. 7 is a schematic structural diagram of a shutter disk in an example of the present disclosure.
FIG. 8 is a schematic structural diagram of a shutter disk in another example of the present disclosure.
FIG. 9 is a schematic top view of a carrier structure in an example of the present disclosure.
FIG. 10 is a cross-sectional side view of the carrier shown in FIG. 9.
FIG. 11 is a schematic top view of a carrier structure in another example of the present disclosure.
FIG. 12 is a cross-sectional side view of the carrier shown in FIG. 11.
FIG. 13 is a schematic diagram illustrating the interaction between the carrier and the shutter disk before the shutter disk being lifted by the conical protrusion.
FIG. 14 is a schematic diagram illustrating the interaction between the carrier and the shutter disk after the shutter disk has been calibrated to a preset position on the carrier.

### Reference numerals

10-Cavity, 101-First Avoidance Hole, 102-First Space, 103-Second Space, 104-Third Space, 11-Insulation Cover, 12-Insulation Ring, 13-Adapter Ring, 14-Cavity Body, 15-Power Supply;
20-Calibration Mechanism, 21-Calibration Rod, 211-Conical Protrusion, 212-Accommodating Recess, 22-Pressure Sensor, 23-First Cylindrical Telescopic Member, 24-First Driving Mechanism, 25-First Flange, 26-Second Flange, 27-Mounting Bracket, 28-Signal Line;
30-Substrate Support, 40-Carrier, 41-Second Avoidance Hole, 42-Limiting Protrusion, 43-Avoidance Notch;
50-Shutter Disk, 51-Conical Groove, 52-Sensor Trigger Protrusion, 53-First Limiting Groove, 54-Second Limiting Groove, 55-Conical Ring Surface;
61-Target Material, 62-Pin, 63-Second Driving Mechanism, 631-Transmission Rod, 64-Deposition Ring, 65-Shielding Ring, 651-Annular Groove, 66-Isolation Ring, 661-Annular Protrusion, 67-Pin Holder, 68-Fourth Driving Mechanism;
71-Magnetron, 72-Third Driving Mechanism, 73-Air Path System.

### DETAILED DESCRIPTION OF THE INVENTION

To facilitate a clearer understanding of the objectives, technical solutions, and advantages of the present disclosure, the following description is provided in conjunction with specific embodiments and corresponding drawings. It should be understood that the embodiments described herein represent only a portion of the disclosure and are not intended to limit its scope. All other embodiments that may be derived by those skilled in the art without inventive effort, based on the disclosed embodiments, are deemed to fall within the scope of the present disclosure.

Sputtering is one of the most widely adopted processes in semiconductor fabrication. In this technique, plasma is used to bombard the surface of a target material, causing atoms to be ejected from the target. These atoms then deposit onto the wafer surface, forming a thin film. However, during target replacement, the exposed surface of the target is prone to adsorbing impurities from the environment. To ensure high film quality, it is therefore essential to perform a thorough cleaning of the target before initiating the sputtering process. Moreover, as sputtering continues over extended periods, reaction byproducts and other contaminants tend to accumulate on the target surface. These residuals can become incorporated into the thin film, potentially degrading its performance and reliability. Consequently, regular cleaning of the target is not merely a preparatory step; it is an essential part of the overall sputtering workflow. During the cleaning process, semiconductor device typically employs a shutter disk to cover the substrate support. This helps prevent impurities from settling onto the substrate support and causing contamination. However, one challenge arises from the fact that the shutter disk can easily shift out of position during operation. Such misalignment may compromise the effectiveness of the shielding and increase the risk of substrate support contamination. To address this issue, existing technologies utilize pins to adjust the position of the shutter disk.

The inventors of the present disclosure have identified a technical drawback in such conventional approaches. Specifically, adjusting the position of the shutter disk via the pins requires relative movement between the shutter disk and the pins. This movement induces friction, which may dislodge impurities adhered to the shutter disk and cause them to fall onto the substrate support, resulting in contamination during the adjustment process. Such contamination not only undermines the effectiveness of the cleaning operation but also adversely affects the quality of the subsequent sputtering process.

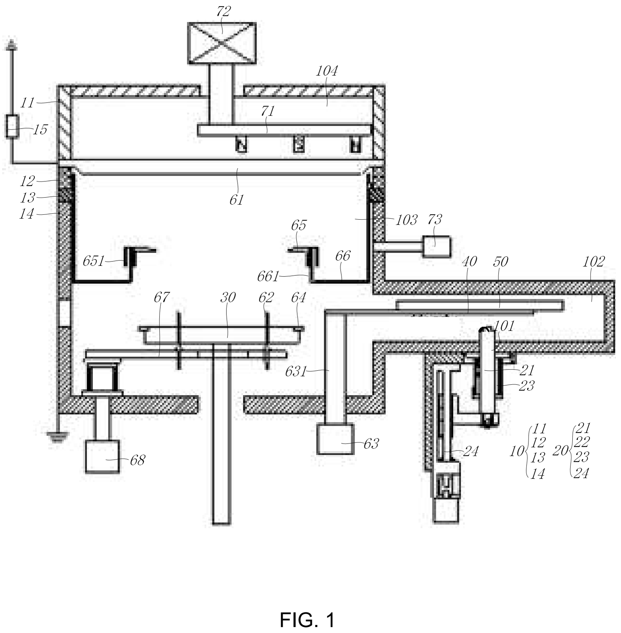

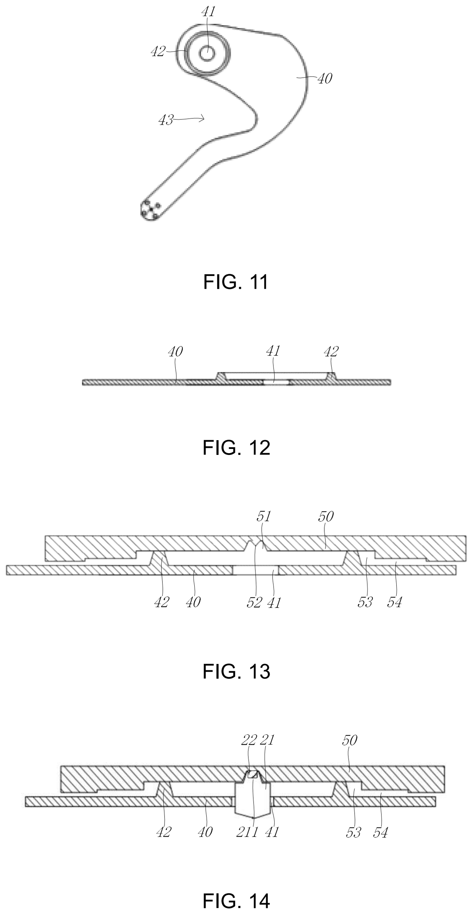

The present disclosure provides a process chamber of a semiconductor process device. The process chamber is a place where the semiconductor process device performs a sputtering process, and is an important component of the semiconductor process device. Referring to FIGs. 1 to 14, the process chamber of the present disclosure comprises a cavity 10, a calibration mechanism 20, a substrate support 30, a carrier 40, and a shutter disk 50.

The cavity 10 is a peripheral structure of the process chamber, and the cavity 10 has a cavity space to accommodate some other components of the process chamber. In some examples of the present disclosure, the substrate support 30, the carrier 40 and the shutter disk 50 are all arranged in the cavity 10 (i.e., arranged in the cavity space).

The calibration mechanism 20 is used for calibrating the position of the shutter disk 50, and the calibration mechanism 20 is provided on the cavity 10. Specifically, the calibration mechanism 20 may all be located in the cavity space, or may be partially located in the cavity space and the other part located outside the cavity space. Certainly, the calibration mechanism 20 may also be provided outside the cavity space, and the calibration mechanism 20 enters the cavity space to perform calibration work when calibration is required. Examples of the present disclosure do not limit the specific arrangement manner and position of the calibration mechanism 20 on the cavity 10, as long as the calibration mechanism 20 can calibrate the position of the shutter disk 50 provided in the cavity space.

The substrate support 30 is used for carrying a wafer. In the sputtering process, the wafer is carried on the substrate support 30, and the plasma in the cavity space bombards the target material 61, thereby bombarding atoms in the target material 61, and the bombarded atoms are deposited on the wafer, thereby realizing sputtering to form a film. The substrate support 30 may be an electrostatic chuck, or may be other components capable of carrying a wafer. Examples of the present disclosure do not limit the specific type of the substrate support 30.

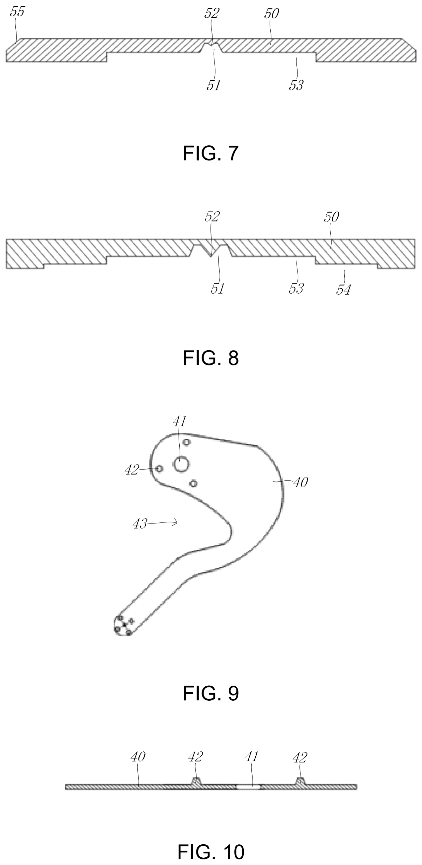

As described in the background, the shutter disk 50 in the examples of the present disclosure is used for covering the bearing surface of the substrate support 30 in the cleaning process, thereby preventing the phenomenon that impurities are deposited on the bearing surface of the substrate support 30 and pollute the bearing surface. The shutter disk 50 is generally a disk-like structure, as shown in FIGs. 7 and 8. As an example, the top end of the shutter disk 50 may be a tapered end, that is, a conical ring surface 55 is formed between the upper surface and the outer peripheral surface of the shutter disk 50, as shown in FIG. 7. As another example, the top end of the shutter disk 50 may also be an equal-diameter end, that is, the angle between the upper surface and the outer peripheral surface of the shutter disk 50 is a right angle. Examples of the present disclosure do not limit the specific shape of the shutter disk 50. It should be noted that the top end of the shutter disk 50 refers to the end facing away from the substrate support 30 when the shutter disk 50 is positioned above the substrate support 30.

The carrier 40 is configured to support the shutter disk 50 during the calibration process. During the sputtering process, the shutter disk 50 may be likewise supported by the carrier 40, allowing the shutter disk 50to be temporarily stored when not in use. Once the position of the shutter disk 50 has been calibrated and the shutter disk 50 is transferred to the substrate support 30 for cleaning, the shutter disk 50 and the carrier 40 may be separated. Accordingly, the carrier 40 does not continuously support the shutter disk 50. Calibration of the shutter disk 50 is required only when it is carried by the carrier 40. In some examples of the present disclosure, the carrier 40 is movably provided on the cavity 10 to drive the shutter disk 50 to implement position switching. As an example, the carrier 40 is rotatably provided in the cavity 10, and the carrier 40 drives the shutter disk 50 to rotate by means of rotation, thereby switching the position of the shutter disk 50. As another example, the carrier 40 is movably provided in the cavity 10, and the carrier 40 drives the shutter disk 50 to move by means of movement, thereby switching the position of the shutter disk 50. Examples of the present disclosure do not limit the specific connection relationship between the carrier 40 and the cavity 10.

In some examples of the present disclosure, in the case that the shutter disk 50 is carried by the carrier 40, the shutter disk 50 can be switched between the first position and the second position along with the carrier 40.

With the shutter disk 50 at the first position, the shutter disk 50 is away from the substrate support 30, and the calibration mechanism 20 can adjust the shutter disk 50 to a preset position adjustment on the carrier 40, thereby enabling position adjustment of the shutter disk 50 at the first position. It should be noted that, in the present disclosure, the shutter disk 50 is away from the substrate support 30, which means that the projection of the shutter disk 50 in the direction perpendicular to the bearing surface of the substrate support 30 does not intersect with the bearing surface of the substrate support 30, and the shutter disk 50 does not cover any area of the bearing surface of the substrate support 30. In other words, the projection of the shutter disk 50 in the direction perpendicular to the bearing surface of the substrate support 30 is located outside the bearing surface of the substrate support 30.

When the shutter disk 50 is at a preset position on the carrier 40, and the carrier 40 drives the shutter disk 50 to move to the second position, the shutter disk 50 is located above the substrate support 30, and the spacing between the first central axis of the shutter disk 50 and the second central axis of the substrate support 30 is less than or equal to the first preset distance. In the present disclosure, the calibration mechanism 20 can adjust the position of the shutter disk 50 on the carrier 40, so that the shutter disk 50 can move to the preset position on the carrier 40, thereby ensuring that when the carrier 40 drives the shutter disk 50 to move to the second position, the spacing between the central axis of the shutter disk 50 and the second central axis of the substrate support 30 is less than or equal to the first preset distance, thereby realizing the centering of the two, and finally achieving calibration success.

As an example, when the shutter disk 50 is at the preset position on the carrier 40, and the carrier 40 drives the shutter disk 50 to move to the second position, the projection of the shutter disk 50 on the bearing surface covers the bearing surface. Specifically, when the distance between the first central axis of the shutter disk 50 and the second central axis of the substrate support 30 is equal to the first preset distance, the relative positional relationship between the shutter disk 50 and the substrate support 30 can just meet the shielding requirements during the cleaning process. As an example, when the distance between the first central axis of the shutter disk 50 and the second central axis of the substrate support 30 is less than the first preset distance, the relative positional relationship between the shutter disk 50 and the substrate support 30 more readily achieves shielding alignment. Conversely, when the spacing between the first central axis of the shutter disk 50 and the second central axis of the substrate support 30 is greater than the first preset distance, it is considered that the shutter disk 50 is away from the substrate support 30, and thus fails to adequately cover the substrate support 30, thereby compromising the intended shielding effect.

The process chamber disclosed in some examples of the present disclosure may further comprise a deposition ring 64, and the deposition ring 64 is disposed around the bearing surface of the substrate support 30. When the shutter disk 50 is moved to the second position, the shielding requirement described above may be that the shutter disk 50 covers the bearing surface and the inner ring edge of the deposition ring 64. It should be noted that, in the present disclosure, the bearing surface is a region on the substrate support 30 for supporting the wafer.

As an example, the first central axis of the shutter disk 50 may coincide with the second central axis of the substrate support 30. In this case, the spacing between the two central axes is zero, which is less than the first preset distance. Under such conditions, the shutter disk 50 and the substrate support 30 achieve optimal centering, resulting in the most effective calibration outcome.

As another example, the first central axis of the shutter disk 50 may be parallel to the second central axis of the substrate support 30. In this case, the spacing between the two central axes is non-zero but remains less than the first preset distance. Under such conditions, although the centering between the shutter disk 50 and the substrate support 30 is slightly less precise, the shielding requirements for the cleaning process are still satisfied. Moreover, the alignment between the calibration structure and the shutter disk 50 is more readily achieved, facilitating implementation of the calibration process.

The process chamber disclosed in the present disclosure improves upon the structural design of process chambers known in the related art. Specifically, the process chamber is configured with the carrier 40 that enables the shutter disk 50 to switch between the first position and the second position. When the shutter disk 50 is at the first position, it is away from the substrate support 30, allowing the calibration mechanism 20 to perform position calibration without interference. This configuration enables the shutter disk 50 to be accurately adjusted to the preset position on the carrier 40. Once the shutter disk 50 is calibrated to the preset position, the carrier 40 may drive the shutter disk 50 to the second position. In this state, the shutter disk 50 remains at the calibrated position and achieves alignment with the substrate support 30 at the second position. By calibrating the shutter disk 50 prior to its movement into alignment with the substrate support 30, this approach avoids performing calibration directly above the substrate support 30. Consequently, although friction during movement of the shutter disk 50 may still generate particles, the configuration prevents such particles from depositing onto the substrate support 30, thereby effectively avoiding contamination during the calibration process.

It should be noted that, in the present disclosure, the shutter disk 50 achieving alignment with the substrate support 30 at the second position while being located at the preset position on the carrier 40 refers to a state in which, when the shutter disk 50 is at the preset position on the carrier 40 and at the second position, the spacing between the first central axis of the shutter disk 50 and the second central axis of the substrate support 30 is less than or equal to the first preset distance. This ensures that, during the cleaning process, the shutter disk 50 can effectively cover the bearing surface of the substrate support 30 as well as the inner edge of the deposition ring 64. In some examples of the present disclosure, the first preset distance may be 1 mm. However, the present disclosure does not limit the specific value of the first preset distance, so long as it satisfies the shielding requirements of the process.

In some examples of the present disclosure, the calibration mechanism 20 may take various forms. For example, the calibration mechanism 20 may be a robotic arm configured to drive the shutter disk 50 to move on the carrier 40 through its own motion, thereby achieving position calibration. The robotic arm may move the shutter disk 50 on the carrier 40 by gripping, adsorption, or other suitable means, so as to position the shutter disk 50 at the preset position on the carrier 40.

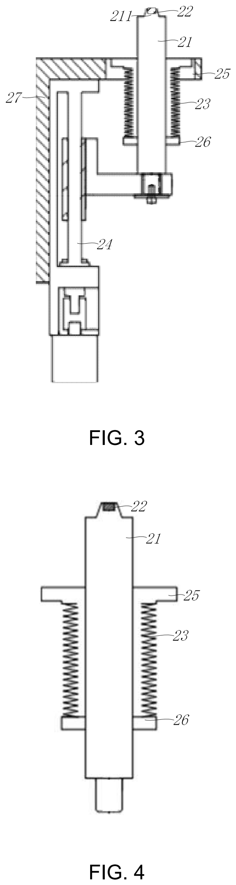

The calibration mechanism 20 may also be implemented in other forms or structures, and the present disclosure imposes no limitation in this regard. Referring to FIGs. 3 to 5, as an example, the calibration mechanism 20 may comprise a calibration rod 21, and the calibration rod 21 is movably provided on the cavity 10, so that the calibration rod 21 can move relative to the cavity 10 during calibration. The top end of the calibration rod 21 may comprise a conical protrusion 211, and the conical protrusion 211 may be a conical structure or a multi-pyramid structure. The bottom surface of the shutter disk 50 facing the carrier 40 may be provided with a conical groove 51, and the shape of the conical groove 51 is adapted to conform to the shape of the conical protrusion 211.

With the shutter disk 50 at the first position, the calibration rod 21 is located below the shutter disk 50. The calibration rod 21 may drive the conical protrusion 211 to pass through the carrier 40 and extend into the conical groove 51, so as to lift the shutter disk. When the shutter disk 50 is lifted by the calibration rod 21, an inner wall of the conical groove 51 slides relative to an outer wall of the conical protrusion 211 under the gravity of the shutter disk 50, to guide the shutter disk 50 to move to the preset position on the carrier 40. In this configuration, the shutter disk 50 can be lifted by the calibration rod 21, and its position on the carrier 40 can be calibrated by utilizing its own weight. During this process, only the vertical movement of the calibration rod 21 needs to be controlled, offering advantages such as simplified operation and a structurally straightforward mechanism. In some examples of the present disclosure, the gravity of the shutter disk 50 drives the inner wall of the conical groove 51 to slide with the outer wall of the conical protrusion 211, so that the spacing between the third central axis of the conical protrusion 211 and the fourth central axis of the conical groove 51 can be guided to be less than the second preset distance, thereby achieving the movement of the shutter disk 50 to the preset position on the carrier 40.

It should be noted that, in the present disclosure, the third central axis of the conical protrusion 211 corresponds to the preset position on the carrier 40. As an example, the gravity of the shutter disk 50 drives the inner wall of the conical groove 51 to slide with the outer wall of the conical protrusion 211, so that the third central axis of the conical protrusion 211 can be guided to coincide with the fourth central axis of the conical groove 51, at which time, the spacing between the third central axis and the fourth central axis is zero. As another example, the gravity of the shutter disk 50 drives the inner wall of the conical groove 51 to slide with the outer wall of the conical protrusion 211, so that the third central axis and the fourth central axis can be guided to be in a parallel state of which the spacing is non-zero but remains less than the second preset distance.

It should be noted that, although the shutter disk 50 may experience slight position deviation due to frequent vertical movement driven by the pins 62, the overall deviation remains limited. By appropriately designing the dimensions of the conical protrusion 211 and the conical groove 51, position calibration of the shutter disk 50 within the allowable deviation range can be achieved, thereby ensuring that the shutter disk 50 is ultimately positioned at the preset position on the carrier 40. Furthermore, the present disclosure does not impose any limitation on the dimensional relationship between the first preset distance and the second preset distance.

As previously described, the calibration process requires the calibration rod 21 to pass through the carrier 40 in order to lift the shutter disk 50. Accordingly, the carrier 40 must be provided with an avoidance structure. The shape of the avoidance structure may vary depending on design requirements. As shown in FIGs. 9 and 10, in an optional solution, the carrier 40 may be provided with a second avoidance hole 41, and a central axis of the second avoidance hole 41 may be collinear with the third central axis of the conical protrusion 211. The calibration rod 21 can drive the conical protrusion 211 to pass through the carrier 41 and extend into the conical groove 51, so as to lift the shutter disk. In this configuration, the second avoidance hole 41 not only serves the avoidance function, but also facilitates positional design of the calibration mechanism 20 on the cavity 10 by aligning the central axis of the second avoidance hole 41 with that of the conical protrusion 211.

In a further technical solution, the calibration mechanism 20 disclosed in the present disclosure may further comprise a pressure sensor 22, the conical protrusion 211 may be provided with an accommodating recess 212, the pressure sensor 22 may be mounted in the accommodating recess 212, and the pressure sensor 22 is flush with or lower than an opening of the accommodating recess 212. The bottom wall of the conical groove 51 may be provided with a sensor trigger protrusion 52. When the conical protrusion 211 extends into the conical groove 51, the sensor trigger protrusion 52 may extend into the accommodating recess 212 and press against the pressure sensor 22. The pressure sensor 22 generates a trigger signal when pressed by the sensor trigger protrusion 52, thereby enabling determination of whether the shutter disk 50 has been properly calibrated. According to the technical solution, by further adding the pressure sensor 22 and the sensor trigger protrusion 52, and by means of the cooperation of the two, the calibration can be further verified when the conical protrusion 211 extends to the conical groove 51. Furthermore, compared to configurations in which the pressure sensor 22 protrudes from the opening of the accommodating recess 212, positioning the pressure sensor 22 flush with or recessed below the opening of the accommodating recess 212 helps prevent false triggering during movement of the calibration rod 21.

The process chamber disclosed in the present disclosure may further comprise an alarm. The alarm is connected to the pressure sensor 22. The alarm is configured to trigger a fault alarm in response to a condition in which the shutter disk 50 is lifted and the pressure sensor 22 fails to output a pressure signal, indicating that the sensor trigger protrusion 52 has not pressed against the pressure sensor 22 and, consequently, that the calibration process has failed. In such a case, the alarm serves to notify the operator and prompt manual intervention. Specifically, the alarm may be implemented as a visual alarm, an audible alarm, or a software-based alert displayed on the control computer interface to facilitate remote monitoring. The alarm may also comprise a combination of visual, audible, and interface-based alerts. It should be noted that the present disclosure does not limit the specific type of alarm used. Furthermore, when the shutter disk 50 deviates excessively, the pressure sensor 22 may fail to output the pressure signal. In such cases, the alarm is likewise triggered in response to the absence of the pressure signal.

To improve triggering accuracy, the process chamber of the present disclosure may be configured such that the sensor trigger protrusion 52 adopts a conical structure. When the conical protrusion 211 extends into the conical groove 51, the smaller end of the sensor trigger protrusion 52 enters the accommodating recess 212 and presses against the pressure sensor 22. In this configuration, the conical sensor trigger protrusion 52 can effectively compress the pressure sensor 22, thereby achieving a more distinct triggering effect.

In one specific implementation, the sensor trigger protrusion 52 may be a truncated cone structure (i.e., the smaller end of the conical structure has a planar end surface). In this case, the sensor trigger protrusion 52 not only activates the pressure sensor 22, but also provides a larger contact area with the pressure sensor 22, thereby offering improved support for the shutter disk 50.

In an alternative implementation, the sensor trigger protrusion 52 may be configured as a pointed cone structure, in which the smaller end converges to a sharp tip. The tip of the sensor trigger protrusion 52 may be positioned along the fourth central axis of the conical groove 51. In this configuration, the pointed cone structure of the sensor trigger protrusion 52 enables more effective compression of the pressure sensor 22, resulting in a clearer triggering response and ultimately facilitating subsequent calibration verification by the pressure sensor 22.

In some examples of the present disclosure, the pressure sensor 22 may be configured as a non-elastic structural member. To improve pressure detection performance, a more feasible solution may employ the pressure sensor 22 as an elastic structural member. In such a configuration, the pressure sensor 22 exhibits favorable deformability, allowing it to undergo significant deformation when compressed by the sensor trigger protrusion 52, thereby facilitating generation of the trigger signal.

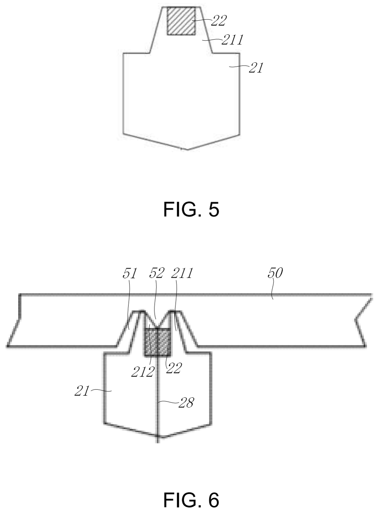

It should be noted that the contact between the sensor trigger protrusion 52 and the pressure sensor 22 may also contribute to supporting the shutter disk 50. Referring to FIG. 6, as an example, the bottom wall of the conical groove 51 may be configured as a first plane, and the top surface of the conical protrusion 211 may be configured as a second plane. When the conical protrusion 211 extends into the conical groove 51, the sensor trigger protrusion 52 enters the accommodating recess 212 and compresses the pressure sensor 22 into a contracted state, while the first and second planes come into contact. In this configuration, when the sensor trigger protrusion 52 activates the pressure sensor 22, the calibration rod 21 not only supports the shutter disk 50 through the contact between the sensor trigger protrusion 52 and the pressure sensor 22, but also provides stable support via the engagement between the first and second planes. This dual-support mechanism helps prevent instability that may arise if the relatively heavy shutter disk 50 were supported solely by the interaction between the sensor trigger protrusion 52 and the pressure sensor 22 during calibration.

In solutions where the sensor trigger protrusion 52 activates the pressure sensor 22 and the first and second planes are engaged, the pressure sensor 22 is preferably formed from an elastic material with good compressibility. This allows the pressure sensor 22 to contract effectively when pressed by the sensor trigger protrusion 52, enabling the shutter disk 50 to descend further and facilitating the engagement of the planes.

In an alternative implementation, the pressure sensor 22 may share between 5% and 50% of the gravitational load of the shutter disk 50 through its interaction with the sensor trigger protrusion 52. The present disclosure does not impose unnecessary limitations on these configurations.

In other implementations, even when the sensor trigger protrusion 52 compresses the pressure sensor 22, the bottom wall of the conical groove 51 and the top surface of the conical protrusion 211 may remain non-contacting.

The calibration mechanism 20 of the present disclosure may further comprise a signal line 28. As shown in FIG. 6, the signal line 28 is electrically connected to the pressure sensor 22 and is configured to transmit the trigger signal generated by the pressure sensor 22. In one optional arrangement, the calibration rod 21 may be provided with a threading hole that communicates with the accommodating recess 212. The end of the signal line 28 passes through the threading hole into the accommodating recess 212 and is electrically connected to the pressure sensor 22 located in the accommodating recess 212. This layout helps prevent wear caused by exposure of the signal line 28 and allows the calibration rod 21 to serve a protective function for the signal line 28. The trigger signal described herein may be the pressure signal detected by the pressure sensor 22.

To facilitate the control or actuation of the vertical movement of the calibration rod 21, an optional solution of the present disclosure provides that the calibration mechanism 20 may further comprise a first cylindrical telescopic member 23. The first cylindrical telescopic member 23 is located outside the cavity 10. The cavity 10 is provided with a first avoidance hole 101, through which the bottom end of the calibration rod 21 extends to the outside of the cavity 10. The first end of the first cylindrical telescopic member 23 is sealingly connected to the first avoidance hole 101, i.e., the first end of the first cylindrical telescopic member 23 is sealingly coupled to the cavity 10 and seals the first avoidance hole 101. The first cylindrical telescopic member 23 is sleeved around the calibration rod 21, and the second end of the first cylindrical telescopic member 23 is in sealing fit with the calibration rod 21. The first cylindrical telescopic member 23 is configured to expand and contract in coordination with the vertical movement of the calibration rod 21. In this configuration, the bottom end of the calibration rod 21 can extend outside the cavity 10, thereby facilitating external operation of the calibration rod 21. Meanwhile, the first cylindrical telescopic member 23 ensures that, while the bottom end of the calibration rod 21 extends outside the cavity 10, a sealed isolation is maintained between the internal and external environments of the cavity 10, thereby preventing external environmental interference with the internal conditions of the cavity 10.

In some examples of the present disclosure, the vertical movement of the calibration rod 21 may be manually controlled. For example, an operator may push or pull the calibration rod 21 by hand to achieve its vertical displacement. Alternatively, the calibration rod 21 may be actuated by a driving mechanism, which enhances the level of automation of the process chamber. Based on this, an optional solution of the present disclosure provides that the calibration mechanism 20 may further comprise a first driving mechanism 24. The first driving mechanism 24 is located outside the cavity 10 and is connected to the bottom end of the calibration rod 21. The first driving mechanism 24 is configured to drive the calibration rod 21 vertically, thereby lifting or separating the shutter disk 50. Since the bottom end of the calibration rod 21 is positioned outside the cavity 10, the first driving mechanism 24 can be conveniently arranged outside the cavity 10 and operate externally, thereby avoiding exposure to the internal environment of the cavity 10.

To facilitate installation, the calibration mechanism 20 disclosed in the present disclosure may further comprise a mounting bracket 27. The first driving mechanism 24 is mounted on the mounting bracket 27. The mounting bracket 27 may be fixed outside the cavity 10, thereby enabling indirect installation of the first driving mechanism 24 onto the cavity 10 and ultimately allowing at least partial installation of the calibration mechanism 20.

As previously described, the first end of the first cylindrical telescopic member 23 is sealingly connected to the first avoidance hole 101. The first cylindrical telescopic member 23 is sleeved around the calibration rod 21, and its second end is sealingly engaged with the calibration rod 21. To facilitate connection, an optional solution of the present disclosure provides that the calibration mechanism 20 may further comprise a first flange 25 and a second flange 26. The second flange 26 is sealingly sleeved around the calibration rod 21, and the outer edge of the upper surface of the second flange 26 is sealingly connected to the second end of the first cylindrical telescopic member 23. The first flange 25 is sleeved around the calibration rod 21 and sealingly connected to the first end of the first cylindrical telescopic member 23. The first flange 25 is fixed within the first avoidance hole 101 and is sealingly engaged with the first avoidance hole 101. This configuration facilitates reliable connection between components of the calibration mechanism 20 and between the calibration mechanism 20 and the cavity 10.

In some examples of the present disclosure, the first driving mechanism 24 may be a pneumatic telescopic member, a hydraulic telescopic member, or a screw-driven mechanism. The present disclosure does not limit the specific type of the first driving mechanism 24. During operation, the movable portion of the first driving mechanism 24 is connected to the bottom end of the calibration rod 21, thereby enabling vertical actuation of the calibration rod 21.

To further enhance automation of the process chamber, an optional solution of the present disclosure provides that the process chamber may further comprise a position detection device and a controller. The position detection device is configured to detect the position of the shutter disk 50. The controller is connected to both the first driving mechanism 24 and the position detection device. The controller is configured to activate the first driving mechanism 24 when the shutter disk 50 is at the first position. In this case, once the position detection device detects that the shutter disk 50 is at the first position, it indicates that the shutter disk 50 either requires calibration or has completed calibration. The controller may then control the calibration rod 21 to move upward or downward accordingly. In some examples of the present disclosure, the position detection device may be a laser-based detector or a vision-based detector. The present disclosure does not limit the specific type of position detection device. The controller may be implemented as a control chip or a Programmable Logic Controller (PLC) control circuit. Again, the present disclosure does not limit the specific type of controller.

Optionally, the lifting stroke of the first driving mechanism 24 may be designed as a preset stroke. During operation, the first driving mechanism 24 drives the calibration rod 21 to rise by the preset stroke, thereby enabling the calibration rod 21 to extend into the conical groove 51 and lift the shutter disk 50. Optionally, the process chamber may utilize a detection device to determine whether the shutter disk 50 has been lifted, and control the activation or deactivation of the first driving mechanism 24 accordingly. The present disclosure does not impose limitations on the control mode for starting or stopping the first driving mechanism 24.

As previously described, when the shutter disk 50 is supported by the carrier 40, the carrier 40 is capable of driving the shutter disk 50 to switch between the first position and the second position. To prevent the shutter disk 50 from slipping off the carrier 40 during position switching, an optional solution of the present disclosure provides that the top surface of the carrier 40 facing the shutter disk 50 is equipped with one or more limiting protrusions 42. The bottom surface of the shutter disk 50 facing the carrier 40 is provided with a first limiting groove 53. The limiting protrusions 42 extend into the first limiting groove 53 and cooperate with the first limiting groove 53 in a limiting fit within a plane parallel to the bearing surface of the substrate support 30. In this configuration, if the shutter disk 50 undergoes lateral displacement, the limiting protrusions 42 and the first limiting groove 53 will engage to restrict further movement, thereby preventing excessive lateral shift and potential slippage.

In some examples of the present disclosure, the limiting protrusions 42 may be configured as annular protrusions, as shown in FIGs. 10, 11, 12, or 13. The annular protrusions extend into the first limiting groove 53 and provide multi-directional constraint within the plane parallel to the bearing surface of the substrate support 30. The number of limiting protrusions 42 may be one or more. FIG. 9 illustrates a configuration comprising three limiting protrusions 42. As shown in FIGs. 8 and 9, when multiple limiting protrusions 42 are provided on the top surface of the carrier 40, the limiting protrusions 42 may be arranged in a circular pattern and extend into the first limiting groove 53 to achieve multi-directional constraint within the plane parallel to the bearing surface of the substrate support 30.

In other examples of the present disclosure, the process chamber of the present disclosure may further comprise pins 62. The bottom surface of the shutter disk 50 facing the carrier 40 may be provided with a second limiting groove 54, with the first limiting groove 53 formed on the bottom wall of the second limiting groove 54. The second limiting groove 54 accommodates the pins 62 and engages with the pins 62 in a limiting fit within the plane parallel to the bearing surface. When the shutter disk 50 is supported by the pins 62 (as described later), the second limiting groove 54 and the pins 62 engage to prevent the shutter disk 50 from detaching. Specifically, the pins 62 may be multiple in number, such as three, and distributed at intervals to provide balanced support.

In some examples of the present disclosure, the process chamber may further comprise a second driving mechanism 63, which is mounted on the cavity 10 and connected to the carrier 40, such that the carrier 40 is driven to move and thereby switch the shutter disk 50 between the first position and the second position. Specifically, the second driving mechanism 63 may be partially located outside the cavity 10 and partially inside. The portion of the second driving mechanism 63 located inside the cavity 10 is connected to the carrier 40 to drive its movement. The second driving mechanism 63 may be of various types, and the present disclosure does not limit its specific form or structure.

In a more detailed implementation, the power output shaft of the second driving mechanism 63 may be configured to rotate within a first preset angular range. When the power output shaft rotates to a first end of the first preset angular range, the second driving mechanism 63 drives the shutter disk 50 to the first position. When the power output shaft rotates to a second end of the first preset angular range, the shutter disk 50 is driven to the second position.

In an optional solution, the second driving mechanism 63 may be connected to the carrier 40 via a transmission rod 631 that extends from outside the cavity 10 into its interior. Specifically, the second driving mechanism 63 is located outside the cavity 10. The cavity 10 is provided with a third avoidance hole. The bottom end of the transmission rod 631 is located outside the cavity 10 and connected to the second driving mechanism 63. The top end of the transmission rod 631 passes through the third avoidance hole into the cavity 10 and connects to the carrier 40. The second driving mechanism 63 drives the transmission rod 631 to rotate, thereby moving the carrier 40. In this configuration, the cavity 10 is provided with the third avoidance hole through which the transmission rod 631 passes. During operation, the second driving mechanism 63 rotates the transmission rod 631, which in turn rotates the carrier 40 and drives the shutter disk 50 to switch positions.

To ensure the internal environment of the cavity 10 remains unaffected, a sealing structure may be provided between the wall of the third avoidance hole and the transmission rod 631. The sealing structure may be dynamic or static, and the present disclosure does not limit its specific type.

Optionally, the cavity 10 of the present disclosure may comprise a first space 102 and a second space 103. The first space 102 is located laterally to the second space 103 and is in communication with the second space 103. The substrate support 30 is disposed within the second space 103, and the calibration mechanism 20 is positioned at a position opposite to the first space 102 within the cavity 10. In examples where the calibration mechanism 20 comprises a calibration rod 21, the calibration rod 21 is movably disposed at a position opposite to the first space 102. The shutter disk 50 is configured to move or rotate within a plane parallel to the bearing surface of the substrate support 30. When the shutter disk 50 is at the first position, the shutter disk 50 moves or rotates into the first space 102. When the shutter disk 50 is at the second position, the shutter disk 50 moves or rotates into the second space 103.

Further, the length of the first space 102 in the first direction is smaller than that of the second space 103 in the same direction. As used herein, the first direction refers to the direction perpendicular to the bearing surface of the substrate support 30. Since the second space 103 containing the substrate support 30 is subject to subsequent sputtering or cleaning processes, while the first space 102 merely serves as a docking area for the shutter disk 50 carried by the carrier 40, the first space 102 does not require a large dimension in the direction perpendicular to the bearing surface. This targeted design of the length dimensions of the first and second spaces 102 and 103 in the first direction facilitates optimized cavity design and avoids unnecessary enlargement, thereby supporting miniaturization of the process chamber.

In some examples of the present disclosure, the process chamber may further comprise a target material 61, a magnetron 71, and a third driving mechanism 72. The cavity 10 may be configured with a second space 103 and a third space 104, separated by the target material 61. The third space 104 is located above the second space 103. The third driving mechanism 72 is arranged on the cavity 10 and connected to the magnetron 71 positioned within the third space 104. The third driving mechanism 72 is configured to rotate the magnetron 71 within the third space 104. It should be noted that the plane in which the magnetron 71 rotates is parallel to the bearing surface of the substrate support 30. During the sputtering process, the third driving mechanism 72 rotates the magnetron 71 within the third space 104, thereby dynamically adjusting the plasma density in the second space 103 via the magnetic field. This results in a more uniform plasma distribution, ultimately improving the sputtering quality.

Similarly, to avoid interference from the internal environment of the cavity 10, the third driving mechanism 72 may be disposed outside the cavity 10 and connected to the magnetron 71 via a connecting member that passes through the cavity 10.

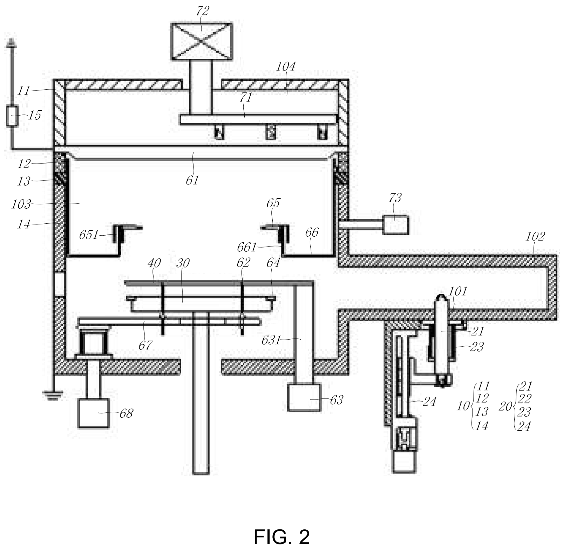

The structure of the cavity 10 may vary, and the present disclosure does not limit its specific configuration. Referring again to FIGs. 1 and 2, as an example, the cavity 10 may comprise an insulation cover 11, an insulation ring 12, and a cavity body 14. The cavity body 14 constitutes the primary structure of the cavity 10. The target material 61 is mounted over the top opening of the cavity body 14 and covers the top opening, thereby enclosing a space that comprises at least the second space 103. In certain examples, this enclosed space may further comprise the first space 102. The insulation cover 11 is disposed above the target material 61 and, in conjunction with the target material 61, defines the third space 104. During sputtering, the target material 61 is electrically connected to the power supply 15. The insulation ring 12 electrically isolates the cavity body 14 from the target material 61, preventing the cavity body 14 from becoming electrically charged. The target material 61 is mounted via overlapping engagement, eliminating the need for a dedicated mounting structure and simplifying the cavity design.

Additionally, the insulation cover 11 and the target material 61 define the third space 104, within which the magnetron 71 is disposed. The insulation cover 11 is made of insulating material to prevent unwanted magnetic field radiation from the third space 104. Specifically, the opening of the insulation cover 11 faces the second space 103, allowing the magnetic field to be selectively applied to the second space 103, thereby enhancing the quality of the sputtering process occurring in the second space 103.

The cavity 10 may further comprise an adapter ring 13, which is disposed between the cavity body 14 and the insulation ring 12 to form part of the cavity 10. The adapter ring 13 functions as a transitional structure that provides a mounting position for the isolation ring 66, thereby facilitating the installation of the isolation ring 66 within the cavity 10.

The process chamber of the present disclosure may also comprise pins 62, a deposition ring 64, a shielding ring 65, an isolation ring 66, a pin holder 67, a fourth driving mechanism 68, and an air path system 73.

The isolation ring 66 is disposed within the cavity 10. One portion of the isolation ring 66 may be affixed to the inner wall of the cavity 10, while another portion of the isolation ring 66 extends above the substrate support 30. The shielding ring 65 is provided with an annular groove 651. The extended portion of the isolation ring 66 forms an annular protrusion 661, which extends into the annular groove 651 of the shielding ring 65. This configuration allows the shielding ring 65 to rest on the annular protrusion 661 by gravity, without being supported by the substrate support 30.

The deposition ring 64 is disposed at the edge of the substrate support 30 and positioned opposite the shielding ring 65. The isolation ring 66, shielding ring 65, and deposition ring 64 are all located within the second space 103 of the cavity 10. More precisely, the first space 102 serves as a docking area for the shutter disk 50 carried by the carrier 40, while the second space 103 is used for cleaning or sputtering processes.

The pins 62 and the pin holder 67 are both disposed within the second space 103. The pins 62 are mounted on the pin holder 67, which is connected to the fourth driving mechanism 68. The fourth driving mechanism 68 is arranged on the cavity 10. The fourth driving mechanism 68 is configured to drive the pin holder 67, thereby indirectly actuating the vertical movement of the pins 62. During operation, the pins 62 extend through the substrate support 30 and are capable of moving vertically in a direction perpendicular to the bearing surface of the substrate support 30.

As an example, the carrier 40 comprises an avoidance notch 43, which is used to play the role of avoiding the pins 62. The process chamber may further comprise the deposition ring 64 fixed to the edge of the substrate support 30 and arranged around the bearing surface of the substrate support 30.

Prior to initiating the cleaning process, the shutter disk 50 is carried by the carrier 40 and moved to the first space 102, where the shutter disk 50 resides in the first position. The calibration mechanism 20 then performs calibration to adjust the shutter disk 50 to the preset position on the carrier 40. Subsequently, the carrier 40 transports the shutter disk 50 into the second space 103, where the shutter disk 50 is positioned at the second position. When the calibrated shutter disk 50 is at the second position within the second space 103, the fourth driving mechanism 68 actuates the pin holder 67 to raise the pins 62. The pins 62 extend through the substrate support 30 and approach the carrier 40, eventually passing through the avoidance notch 43 to support the shutter disk 50. Once the shutter disk 50 is supported by the pins 62, the carrier 40 may be driven by the second driving mechanism 63 to move back to the first space 102. The avoidance notch 43 ensures clearance between the carrier 40 and the raised pins 62 during this movement, thereby preventing interference. Next, the substrate support 30 is elevated by a fifth driving mechanism (not shown), thereby lifting the shutter disk 50 until the deposition ring 64 engages and raises the shielding ring 65, while maintaining the annular protrusion 661 of the isolation ring 66 securely engaged within the annular groove 651. At this stage, the shutter disk 50 is positioned at the cleaning process position, supported by the substrate support 30 and covering the bearing surface to protect the substrate support 30 in preparation for the subsequent cleaning operation.

It should be noted that the projection of the shielding ring 65 in the direction perpendicular to the bearing surface of the substrate support 30 may cover the outer edge of the deposition ring 64. As the substrate support 30 continues to ascend, the substrate support 30 lifts both the shutter disk 50 and the deposition ring 64, thereby causing the shielding ring 65 to rise. In this configuration, the target material 61, isolation ring 66, shielding ring 65, deposition ring 64, and shutter disk 50 together define a cleaning space, completing the preparation for the cleaning process. During cleaning, the air path system 73 delivers a cleaning gas (e.g., argon or nitrogen) into the cleaning space. The cleaning gas is ionized into plasma, which bombards the target material 61 to remove impurities, thereby achieving target cleaning. Naturally, the atomized impurities may deposit onto the shutter disk 50, isolation ring 66, shielding ring 65, and deposition ring 64. Since the shutter disk 50 covers the substrate support 30, the shutter disk 50 serves to protect the substrate support 30 from impurity deposition.

Upon completion of the cleaning process, the fifth driving mechanism lowers the substrate support 30, thereby causing the shutter disk 50 to descend along with the substrate support 30. As the downward movement continues, the pins 62 extend once again from the side of the bearing surface of the substrate support 30 to re-engage and support the shutter disk 50, resulting in separation of the shutter disk 50 from the substrate support 30. The second driving mechanism 63 subsequently drives the carrier 40 from the first space 102 into the second space 103, positioning the carrier 40 beneath the shutter disk 50, while the substrate support 30 is located below the carrier 40. Then, the fourth driving mechanism 68 actuates the pin holder 67 to lower the pins 62, thereby allowing the shutter disk 50 to descend onto the carrier 40. As the pins 62 continue to descend, the shutter disk 50 separates from the pins 62. The second driving mechanism 63 then moves the carrier 40 and the shutter disk 50 from the second space 103 back to the first space 102, returning the shutter disk 50 to the first position for recalibration by the calibration mechanism 20. The recalibrated shutter disk 50 is then ready for the next cleaning cycle.

Upon completion of the cleaning process, the robotic arm of the semiconductor process device may place the wafer onto the pins 62, which are configured to support the wafer. The fifth driving mechanism subsequently elevates the substrate support 30, thereby lifting the wafer and effecting separation between the wafer and the pins 62. When the substrate support 30 is raised to the position where the deposition ring 64 contacts the shielding ring 65, the air path system 73 may introduce a process gas (e.g., argon or nitrogen). The process gas enters the second space 103 and is ionized into plasma. The plasma bombards the cleaned target material 61, ejecting atoms from the target material 61, which are then deposited onto the wafer, thereby performing the sputtering process.

As previously described, the bottom surface of the shutter disk 50 may be provided with the second limiting groove 54, which is configured to engage with the pins 62 for positional constraint. Specifically, when the shutter disk 50 is supported by the pins 62, the pins 62 extend into the second limiting groove 54 and engage with the sidewalls of the second limiting groove 54 to prevent lateral displacement or accidental detachment of the shutter disk 50. The presence of the second limiting groove 54 is not contingent upon the existence of the first limiting groove 53. However, if the shutter disk 50 is already provided with the first limiting groove 53, the first limiting groove 53 may be formed on the bottom wall of the second limiting groove 54 and may be concentrically aligned with the second limiting groove 54.

Based on the process chamber disclosed herein, the present disclosure further provides a semiconductor process device that comprises the aforementioned process chamber.

The foregoing examples primarily illustrate the distinctions among various implementations. Provided that the respective technical features are not mutually exclusive, such features may be combined to form additional implementations. For conciseness, these potential combinations are not exhaustively detailed herein.

The examples of the present disclosure have been described with reference to the accompanying drawings. However, these examples are provided solely for illustrative purposes and are not intended to limit the scope of the present disclosure. Various modifications and adaptations may be made by those skilled in the art without departing from the spirit or scope of the present disclosure as defined by the appended claims, and all such variations are intended to be encompassed within the scope of the present disclosure.

## Claims

1. A semiconductor process chamber, comprising:
a cavity, a calibration mechanism, a substrate support disposed in the interior volume of the cavity, a carrier, a shutter disk, wherein the calibration mechanism is arranged above the cavity;
wherein when the shutter disk is supported by the carrier, the shutter disk switches between a first position and a second position along with the carrier;
wherein when the shutter disk is at the first position, the shutter disk is away from the substrate support, and the calibration mechanism adjusts the shutter disk to a preset position on the carrier;
wherein when the shutter disk is located at the preset position on the carrier, the carrier drives the shutter disk to move to the second position, wherein the shutter disk is disposed above the substrate support, wherein a spacing between a first central axis of the shutter disk and a second central axis of the substrate support is less than or equal to a first preset distance.

2. The semiconductor process chamber according to claim 1, wherein the calibration mechanism comprises a calibration rod movably arranged on the cavity, wherein a top end of the calibration rod comprises a conical protrusion, and a bottom surface of the shutter disk facing the carrier comprises a conical groove;
wherein when the shutter disk is located at the first position, the calibration rod is located below the shutter disk, and the calibration rod is configured to drive the conical protrusion to pass through the carrier and extend into the conical groove, so as to lift the shutter disk; and
during the process of the shutter disk being lifted, an inner wall of the conical groove slides relative to an outer wall of the conical protrusion under the gravity of the shutter disk, to guide the shutter disk to move to the preset position on the carrier.

3. The semiconductor process chamber according to claim 2, wherein the calibration mechanism further comprises a pressure sensor, the conical protrusion is provided with an accommodating recess, the pressure sensor is mounted in the accommodating recess, and the pressure sensor is flush with or lower than an opening of the accommodating recess, wherein a bottom wall of the conical groove is provided with a sensor trigger protrusion; and
wherein when the conical protrusion extends into the conical groove, the sensor trigger protrusion enters the accommodating recess and presses the pressure sensor.

4. The semiconductor process chamber according to claim 3, wherein the process chamber further comprises an alarm, wherein the alarm is connected to the pressure sensor, and is configured to trigger a fault alarm in response to a condition in which the shutter disk is lifted and the pressure sensor fails to output a pressure signal.

5. The semiconductor process chamber according to claim 3, wherein the sensor trigger protrusion is a conical structure, and when the conical protrusion extends into the conical groove, a smaller end of the sensor trigger protrusion enters the accommodating recess and presses the pressure sensor.

6. The semiconductor process chamber according to claim 3, wherein the pressure sensor is an elastic structural member, the bottom wall of the conical groove is configured as a first plane, and a top surface of the conical protrusion is configured as a second plane, wherein when the conical protrusion extends into the conical groove, the sensor trigger protrusion enters the accommodating recess and presses the pressure sensor to a contracted state, and the first plane comes into contact with the second plane.

7. The semiconductor process chamber according to claim 2, wherein the calibration mechanism further comprises a first cylindrical telescopic member located outside the cavity, the cavity is provided with a first avoidance hole, and a bottom end of the calibration rod passes through the first avoidance hole and is located outside the cavity, wherein a first end of the first cylindrical telescopic member is sealed and engaged with the first avoidance hole, the first cylindrical telescopic member is sleeved around the calibration rod, a second end of the first cylindrical telescopic member is in sealing fit with the calibration rod, and the first cylindrical telescopic member is configured to expand and contract in response to a vertical movement of the calibration rod.

8. The semiconductor process chamber according to claim 7, wherein the calibration mechanism further comprises a first driving mechanism, the first driving mechanism is located outside the cavity and is connected to the bottom end of the calibration rod, and the first driving mechanism is configured to drive the calibration rod to ascend or descend to lift the shutter disk or separate from the shutter disk.

9. The semiconductor process chamber according to claim 2, wherein the carrier is provided with a second avoidance hole, and the calibration rod is configured to drive the conical protrusion to pass through the second avoidance hole and extend into the conical groove.

10. The semiconductor process chamber according to claim 1, wherein a top surface of the carrier facing the shutter disk is provided with one or more limiting protrusions, a bottom surface of the shutter disk facing the carrier is provided with a first limiting groove, and one of the limiting protrusions extends into the first limiting groove and cooperates with the first limiting groove in a limiting fit within a plane parallel to a bearing surface of the substrate support.

11. The semiconductor process chamber according to claim 10, wherein the one or more limiting protrusions is one annular protrusion, or multiple limiting protrusions circumferentially arranged on the top surface of the carrier.

12. The semiconductor process chamber according to claim 10, wherein the process chamber further comprises pins, wherein the bottom surface of the shutter disk facing the carrier is further provided with a second limiting groove, and the first limiting groove is arranged on a bottom wall of the second limiting groove, wherein the pins extend into the second limiting groove and cooperate with the second limiting groove in a limiting fit within the plane parallel to the bearing surface of the substrate support.

13. A semiconductor process device comprising the semiconductor process chamber according to any one of claims 1 to 12.
